# DEMANDE DE BREVET EUROPEEN

(11) **EP 1 329 436 A2**
(43) Date de publication de la demande: **23.07.2003**
(21) Numéro de dépôt: 03290144.9
(22) Date de dépôt: 21.01.2003
(51) Int. Cl.: C04B 35/583, C04B 35/622, C08G 79/08, C01B 21/064

(54) **Procede de fabrication de fibres de nitrure de bore a partir de borylborazines**

(30) Priorité: 22.01.2002 FR 0200758
(71) Demandeur: EADS Launch Vehicles, 75781 Paris Cedex 16 (FR)
(72) Inventeur: Miele, Philippe, 69006 Lyon (FR); Toury, Bérangère, 94130 Nogent sur Marne (FR); Bernard, Samuel, 69100 Villeurbanne (FR); Cornu, David, 69100 Villeurbanne (FR); Ayadi, Khaled, 42300 Roanne (FR); Rousseau, Loic, 33160 Saint Aubin de Medoc (FR); Beauhaire, Guy, 78380 Bougival (FR)
(74) Mandataire: Audier, Philippe André

(57) **Abrégé**

La présente invention a pour objet un procédé de fabrication de fibres de nitrure de bore, en particulier de fibres continues de nitrure de bore ayant de bonnes propriétés mécaniques, utilisables pour la réalisation de matériaux composites céramiques tels que des composites BN/BN, des pièces thermostructurales ou des radômes d'antennes.

Elle fournit et utilise un polymère précurseur de formule (I) suivante : 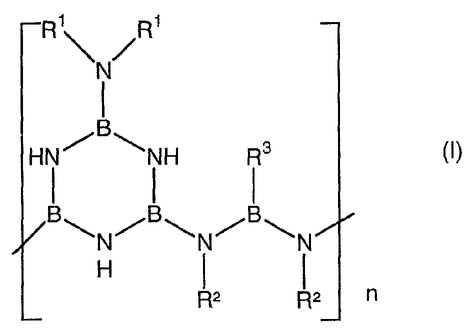 dans laquelle n est un nombre entier, R¹ et R², identiques ou différents, représentent indépendamment un groupe alkyle, et R³ représente un groupe amino, un atome d'hydrogène, un alkyle, un cycloalkyle ou un boryle.

## Description

### DOMAINE TECHNIQUE

La présente invention a pour objet un procédé de fabrication de fibres de nitrure de bore, en particulier de fibres continues de nitrure de bore ayant de bonnes propriétés mécaniques, utilisables pour la réalisation de matériaux composites céramiques tels que des composites BN/BN, des pièces thermostructurales ou des radômes d'antennes.

De façon plus précise, elle concerne l'obtention de fibres de nitrure de bore à partir d'un précurseur polymère que l'on met en forme par filage pour former des fibres de polymère qui sont soumises ensuite à une céramisation pour les transformer en fibres de nitrure de bore.

Les fibres céramiques de nitrure de bore de la présente invention sont d'un grand intérêt pour la fabrication de matériaux composites ayant de bonnes propriétés de résistance à l'oxydation, de stabilité thermique, et d'isolation électrique.

Pour les matériaux composites, notamment à matrice céramique, il est en effet préférable de disposer de fibres continues pour améliorer la résistance à la fracture de la céramique.

Par ailleurs, il est nécessaire d'utiliser des fibres souples ayant des résistances à la traction élevées.

### ÉTAT DE LA TECHNIQUE ANTERIEURE

Les références entre crochets **[ ]** renvoient à la liste de références annexée.

Il existe de nombreux procédés de fabrication de nitrure de bore, comme il est décrit par R.T. PAINE et al, **[1].** Parmi les méthodes décrites dans ce document, on trouve en particulier des procédés utilisant des polymères précurseurs formés à partir de composés inorganiques de bore tels que des borazènes.

Une façon d'obtenir de tels polymères précurseurs a été décrite par C. K. Narula et al **[2]**. Elle consiste à faire réagir le trichloroborazine ou le 2-(diméthylamino)-4,6-dichloroborazine avec l'hexa-méthyldisilazane en solution dans le dichlorométhane à température ambiante. Dans le cas où on utilise le 2-(diméthyl-amino)-4,6-dichloroborazine, on favorise la polymérisation en deux points en raison de la présence du groupe NMe₂.

Une autre façon d'obtenir des polymères précurseurs décrite dans EP-A-0 342 673 **[3]**, consiste à faire réagir un B-tris (alkyl inférieur amino) borazine avec une alkylamine telle que la laurylamine, thermiquement en masse ou en solution.

On peut encore obtenir d'autres polymères précurseurs par polycondensation thermique d'aminoborazines trifonctionnels de formule [-B(NR¹R²)-NR³-]₃ dans laquelle R¹, R² et R³ qui sont identiques ou différents représentent l'hydrogène, un radical alkyle ou un radical aryle, comme il est décrit dans FR-A-2 695 645 **[4].**

Les polymères décrits ci-dessus conviennent bien pour l'obtention de poudre ou d'autres formes de nitrure de bore mais il est plus difficile de préparer des formes plus complexes, en particulier des fibres à partir de tels polymères.

Souvent, en effet, l'étirage du polymère précurseur nécessaire à la mise en forme de fibres se fait mal en raison de sa structure réticulée statistique, qui conduit à peu d'allongement, rendant la maîtrise de la section de la fibre très aléatoire. Plus loin, dans le procédé, cela se traduit par des ruptures de fibres ou des points faibles, qui conduisent à des propriétés mécaniques finales très faibles.

Aussi, comme il est indiqué par T. Wideman et al **[5],** les recherches ont été poursuivies pour trouver d'autres polymères précurseurs convenant mieux pour l'obtention de fibres de nitrure de bore. Dans ce document, il est indiqué qu'un polymère précurseur filable à l'état fondu peut être obtenu en modifiant du polyborazylène par réaction avec une dialkylamine.

Il apparaît donc que de nombreuses voies ont été envisagées pour réaliser des fibres de nitrure de bore, mais sans succès.

Les matériaux obtenus dans l'art antérieur sont des matrices ou du BN massif, mais pas des fibres continues de nitrure de bore de bonne qualité indispensable pour la fabrication de matériaux composites céramiques ayant de bonnes performances mécaniques.

### EXPOSE DE L'INVENTION

La présente invention a précisément pour but de pallier les inconvénients précités de l'art antérieur et de fournir un polymère précurseur de fibres qui présente les qualités précitées requises notamment pour la fabrication de fibres de nitrures de bore.

Ce but est atteint, selon la présente invention, en utilisant le polymère précurseur de formule (I) suivante : 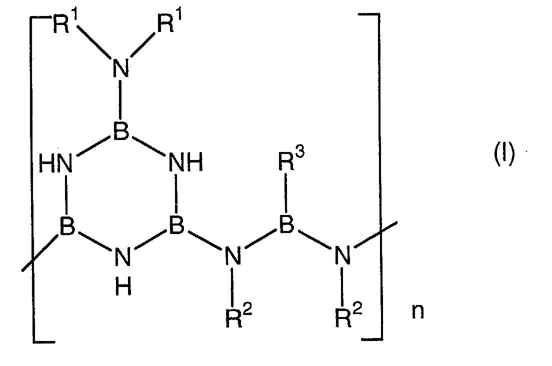 dans laquelle n est un nombre entier, R¹ et R², identiques ou différents, représentent indépendamment un groupe alkyle, et R³ représente un groupe amino, un atome d'hydrogène, un alkyle, un cycloalkyle ou un boryle.

Avantageusement, selon la présente invention, le groupe alkyle R¹ représente le groupe méthyle. Il peut cependant représenter d'autres alkyles, par exemple à deux ou trois carbones.

Avantageusement, selon la présente invention, le groupe alkyle R² représente le groupe méthyle. Il peut cependant représenter indépendamment de R¹ d'autres alkyles, par exemple à deux ou trois carbones, par exemple l'éthyle ou le propyle.

Avantageusement, selon la présente invention, le groupe alkyle R³ représente une alkylamine, comprenant par exemple de 1 à 3 atomes de carbone, de préférence R³ est NHCH₃.

Cette structure apporte une grande souplesse au polymère obtenu qui peut être mis en forme de fil très facilement. Il permet par céramisation de ces fils d'obtenir des fibres de nitrure de bore.

Aussi, la présente invention se rapporte également à un procédé de fabrication de fibres de nitrure de bore par filage d'un polymère précurseur et céramisation des fibres de polymère obtenues par filage, dans lequel le polymère précurseur est de formule (I) définie ci-dessus.

Avantageusement, selon la présente invention, le polymère précurseur peut être obtenu par la mise en oeuvre des étapes suivantes :
- réaction de HN(R¹)₂ sur la trichloroborazine en proportion stoechiométrique 1/1 en moles pour donner le borazine de formule (II) suivante : 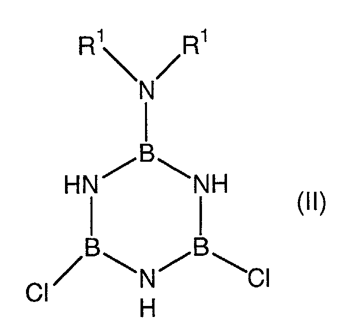
- réaction sans chauffage du borazine de formule (II) avec un alkylaminoborane de formule R³B(NHR²)₂ en proportions stoechiométriques 1/1 en moles, en présence d'une amine tertiaire -N(R⁴)₃.
dans lequel R¹, R² et R³ étant tels que définis ci-dessus et R⁴ est un groupe alkyle.

Selon la présente invention, R⁴ est avantageusement un groupe alkyle comprenant de 1 à 3 atomes de carbone, de préférence un éthyle.

La technique utilisée dans l'invention repose sur la polymérisation chimique de borazines.

Le procédé demande un respect, de préférence le plus précis possible, des quantités stoechiométriques entre le borazine de formule (II) et l'alkylaminoborane R³B(NHR²)₂, c'est à dire des proportions molaires 1/1 de ces deux composés.

Le trisméthylaminoborane, avec R² = CH₃ et R³ = NHCH₃ dans le composé de formule (III), est l'aminoborane préféré pour la synthèse du polymère précurseur car les groupements NHMe présentent une très grande réactivité vis à vis des atomes de chlore.

L'introduction des réactifs de départ est avantageusement bien contrôlée (masse stricte) pour obtenir le polymère désiré.

La présente invention utilise donc un polymère de type borylborazine peu réticulé obtenu sans chauffage, c'est à dire à température ambiante, par exemple à une température de 10 à 35°C, pour la fabrication de fibres de nitrure de bore.

Selon l'invention, pour former les bouts de chaînes, un léger excès d'amine HN(R¹)₂ peut être ajouté au début de la synthèse du composé (II) ce qui implique une faible proportion de borazines disubstitués de formule (NR¹)₂ClB₃N₃H₃ qui serviront de bloqueurs de chaîne pour limiter le taux de polycondensation.

Il est aussi possible de faire réagir une alkylamine HNR⁵R⁶ sur le polymère obtenu en solution pour substituer *in-fine* les atomes de chlore des bouts de chaînes, R⁵ et R⁶ étant indépendamment un alkyle, aryle ou boryle. La proportion de groupements bloqueurs de chaîne détermine la répétition n du motif de base de formule (I). Celui-ci (n) étant par exemple compris entre 5 et 30, préférentiellement entre 10 et 20. La polymérisation par le groupement boryle pontant ne peut cependant pas être exclue, bien que très peu probable à cause de l'encombrement stérique. C'est pourquoi, dans le cas où R³ est un groupe alkylamino le polymère peut être légèrement réticulé.

Selon l'invention, la polymérisation est de préférence effectuée sous atmosphère inerte.

Une fois la réaction terminée, le polymère soluble dans le solvant peut être séparé du chlorhydrate d'amine N(R₄)₃.HCl par exemple par filtration et le solvant peut être éliminé par exemple par évaporation sous pression réduite.

Avantageusement, selon l'invention, le polymère peut être refondu après sa synthèse pour l'homogénéiser et le rendre compact avant le filage. Ceci peut être réalisé par exemple par une brève montée en température, jusqu'à sa température de ramollissement.

Selon l'invention, l'étape de filage s'effectue préférablement sous atmosphère contrôlée et les inventeurs ont remarqué qu'il était préférable de maintenir le taux d'humidité relatif de cette atmosphère à une valeur inférieure à 10 % et de préférence inférieure à 2 %.

Pour le filage, le polymère peut être extrudé par une filière de 50 à 500 µm et plus particulièrement de 100 à 200 µm, qui est surmontée d'un filtre et d'un élément de cisaillement. L'étirage du fil polymérique peut se faire à l'aide d'une bobine réfractaire de diamètre compris entre 50 et 200 mm, et plus précisément de 50 à 100 mm. Cette bobine peut être par exemple en graphite.

La présente invention permet avantageusement de diminuer de 30 à 100°C la température de filage par rapport aux polymères et procédés de l'art antérieur.

Pour obtenir de bons résultats, de préférence, le filage est réalisé à une température de filage Tf telle que 30°C ≤ Tf - Tg ≤ 100°C, de préférence telle que 30°C ≤ Tf - Tg ≤ 70°C, avec Tg, la température de transition vitreuse du polymère.

La température de transition vitreuse du polymère de la présente invention est d'environ 25 à 80°C, selon la valeur de n ou la proportion de borazine (III).

Le polymère précurseur de formule (I) de la présente invention présente la particularité de posséder une structure pseudo-linéaire ou peu réticulée car un des trois sites du précurseur trichloroborazine (TCB) de départ est rendu non réactif. La dispersion des masses moléculaires est donc plus restreinte.

En outre, la polycondensation chimique de la présente invention permet la formation d'un polymère dont les cycles boraziniques B₃N₃ sont reliés uniquement par des liaisons intercycliques à trois atomes de type N-B-N originaux. Le mécanisme de polycondensation est donc univoque. A température ambiante, c'est à dire à environ 10 à 35°C, par exemple à 25°C environ, les protons cycliques ne sont pas assez réactifs pour réagir sur les atomes de chlore. La formation de ponts à 3 atomes entre deux cycles est donc le seul mécanisme possible.

De plus, la structure particulière du polymère de la présente invention permet de contrôler le nombre de cycles par chaînes et ainsi de contrôler la masse moléculaire du polymère et donc sa température de transition vitreuse.

Cette structure de la présente invention améliore les caractéristiques rhéologiques des polymères obtenus et apporte une grande souplesse au polymère qui peut être filé très facilement.

Les avantages du procédé de la présente invention utilisant ce polymère particulier sont multiples.

On peut citer par exemple une polycondensation plus rapide, à température ambiante ce qui est très intéressant d'un point de vue énergétique. Le gain de temps est considérable car la polymérisation est réalisée par réaction chimique à basse température, donc sans thermolyse.

De plus, grâce au procédé de la présente invention, et à l'univocité du mécanisme de polycondensation seule la création de ponts à trois atomes entre les cycles boraziniques est possible.

De plus le rendement céramique est relativement élevé car le polymère contient des groupements alkyle de type méthyle. Ce rendement peut atteindre 50%.

Par rapport aux polycondensations thermiques de l'art antérieur le procédé de la présente invention fourni en outre un meilleur contrôle de l'avancement du polymère. En effet, les quantités de réactifs au départ peuvent être additionnés en quantités contrôlées ce qui permet l'obtention d'un polymère dont la masse moléculaire peut être maîtrisée.

Selon la présente invention, le traitement de céramisation peut être effectué par les méthodes classiques généralement utilisées pour la transformation des fibres de polymères précurseurs à base d'aminoborazines en nitrure de bore, en les soumettant à un traitement thermique en présence d'ammoniac, puis d'azote et éventuellement d'un gaz inerte tel que l'argon.

Selon l'invention, l'étape de céramisation est avantageusement réalisée en deux étapes, en réalisant une première étape de précéramisation avec de l'ammoniac jusqu'à une température inférieure ou égale à 1000°C, puis en réalisant une deuxième étape de céramisation en atmosphère d'azote et/ou de gaz rare à des températures supérieures, notamment de 1400 à 2200°C, en une ou plusieurs opérations successives.

Pour ces traitements, on peut utiliser une rampe de chauffage qui permet d'augmenter la température à une vitesse de 5 à 1000°C/h, de préférence de 15 à 700°C/h.

La fibre de nitrure de bore à haute performance obtenue à partir du polymère de la présente invention est une fibre continue et tissable de nitrure de bore hexagonal, sous forme de monofilament ou de mèche de filaments, et le(s) filament(s) présentent une contrainte moyenne à la rupture σ_{R} d'au moins 800 MPa, de préférence de 800 à 2000 MPa, un module d'Young moyen E de 50 à 250 GPa, de préférence de 50 à 190 GPa et une distribution des allongements à la rupture moyens ε_{R} de 0,2 à 2 %, et de préférence de 0,2 à 1 %.

On précise que la contrainte à rupture médiane σ_{R} est déterminée sur une cinquantaine de filaments en longueur d'éprouvette de 1 cm. Les tests de rupture sont analysés par le modèle de Weibull où les contraintes à rupture médianes sont déterminées pour une probabilité de rupture égale à 0,63. On définit une valeur moyenne de la distribution des allongements à la rupture moyens (ε_{R}) et à partir de cette valeur, on calcule la valeur médiane de la distribution des contraintes à rupture (σ_{R}) à une probabilité de survie de 0,63. On peut alors en déduire le module d'Young moyen ou d'élasticité E.

Selon l'invention, le diamètre du ou des filaments constituant la fibre est de préférence 4 à 25 µm.

Le nitrure de bore formant les fibres est du nitrure de bore hexagonal. Cette structure correspond à un empilement de plans hexagonaux de BN. Une telle structure est décrite par exemple dans la demande FR-A-2 806 422.

Selon l'invention, la fibre présente avantageusement un taux d'impuretés inférieur à 1 %, en particulier elle contient moins de 0,1 % en poids au total d'éléments de numéro atomique supérieur à 11, et présente une masse volumique égale ou supérieure à 1,8 g/cm³.

Par ailleurs, la fibre conserve ses performances élevées en vieillissement naturel. En effet, en vieillissement accéléré, à 65°C, dans une atmosphère à 75 % d'humidité relative, on ne dénote aucune diminution mesurable des propriétés mécaniques au bout de deux mois.

Les fibres de la présente invention présentent une excellente filabilité et permettent par conséquent un filage facile, alors qu'avec les polymères de l'art antérieur cette étape est très délicate. Les fibres obtenues sont des fibres continues de haute performance.

Les applications industrielles de la présente invention sont nombreuses, parmi elles ont peut citer de manière générale la fabrication de matériaux composites, à titre d'exemple, la fabrication de fibres de nitrure de bore utilisables par exemple pour la réalisation de composites BN/BN, de pièces structurales, ou de radômes d'antennes hautes températures structuraux.

Ces fibres peuvent être utilisées par exemple seules, mais aussi dans une matrice de résine, par exemple époxy ou dans une matrice céramique pour la fabrication de pièces structurales, par exemple dans l'automobile, l'aviation, et les machines de manière générale etc.

En outre, selon la présente invention, le polymère de formule (I) décrite ci-dessus peut être avantageusement utilisé pour la fabrication de revêtements protecteurs contre l'oxydation, de mousses de nitrure de bore, de matériaux composites BN/C ou BN/BN ou de puits de chaleur pour la microélectronique.

D'autres avantages et caractéristiques de la présente invention apparaîtrons encore à l'homme du métier à la lumière des exemples ci-dessous donnés à titre illustratif et non limitatif.

### EXEMPLES

### EXEMPLE 1 : SYNTHESE DU POLYMERE :

4,8g de 2,4,6-trichloroborazine (TCB = Cl₃B₃N₃H₃) ont été solubilisés dans 120ml de toluène et 10ml de triéthylamine (1 équivalent). On a ensuite additionné par cryopompage 1,175g de Me₂NH à la solution obtenue. Après filtration, et évaporation sous vide du solvant, on a obtenu le borazine : (NMe₂)Cl₂B₃N₃H₃ (a).

Cette première étape consiste à préparer notamment un monomère de type borazine dont une des trois fonctions est rendue non réactive à la température de la synthèse, c'est à dire à la température ambiante. Ce monomère ne comporte plus que deux fonctions « chlore » réactives. Lors de cette réaction, un atome de chlore du TCB est remplacé par un groupement N(CH₃)₂ et il y a libération d'un équivalent de HC1. Cette espèce est gazeuse dans ces conditions et peut être captée par un équivalent de triéthylamine (Et₃N) en formant un composé solide qui précipite Et₃N.HCl.

Après cette première étape on a additionné à l'aide d'une ampoule de coulée le borazine modifié (1 équivalent), 15ml de triéthylamine sur 2,21g de B(NHMe)₃ solubilisé dans 50ml de toluène. Après agitation, filtration et évaporation, on a obtenu 4,3g d'un solide poudreux orange clair soluble dans la plupart des solvants organiques. Le polymère a alors été introduit dans un réacteur puis refondu jusqu'à 150°C sous argon.

Cette deuxième étape concerne la préparation du polymère. La réaction est similaire à celle décrite plus haut, c'est à dire que l'alkylaminoborane peut réagir avec une fonction chlore par l'intermédiaire de ses fonctions NHCH₃ en formant un composé intermédiaire non isolable, qui peut à son tour réagir sur une molécule identique. La réitération de ce processus conduit à la formation du polymère (b).

La substitution préalable d'un des atomes de bore du cycle par NR₂ permet l'orientation de la polycondensation selon les deux directions restantes. De plus, l'encombrement stérique dû aux groupements NMeH restant sur le pont intercyclique empêche l'approche d'un autre cycle dans la direction du groupement -NMeH restant sur le pont intercyclique.

Le polymère obtenu a été identifié comme étant le polymère (b) indiqué sur la figure 1 ci-dessous, dans lequel n est un nombre entier, allant par exemple de 5 à 30, de préférence de 10 à 20.

Il est constitué de cycles reliés exclusivement par des ponts à trois atomes N-B-N et est donc pseudolinéaire et peu réticulé. Le bout des chaînes est formé par un groupement N(CH₃)₂ supplémentaire présent sur une faible proportion des monomères.

La température de ramollissement mesurée de ce polymère était d'environ 140°C.

L'analyse en calorimétrie différentielle DSC réalisée sur ce produit a indiqué une Tg de l'ordre de 25°C.

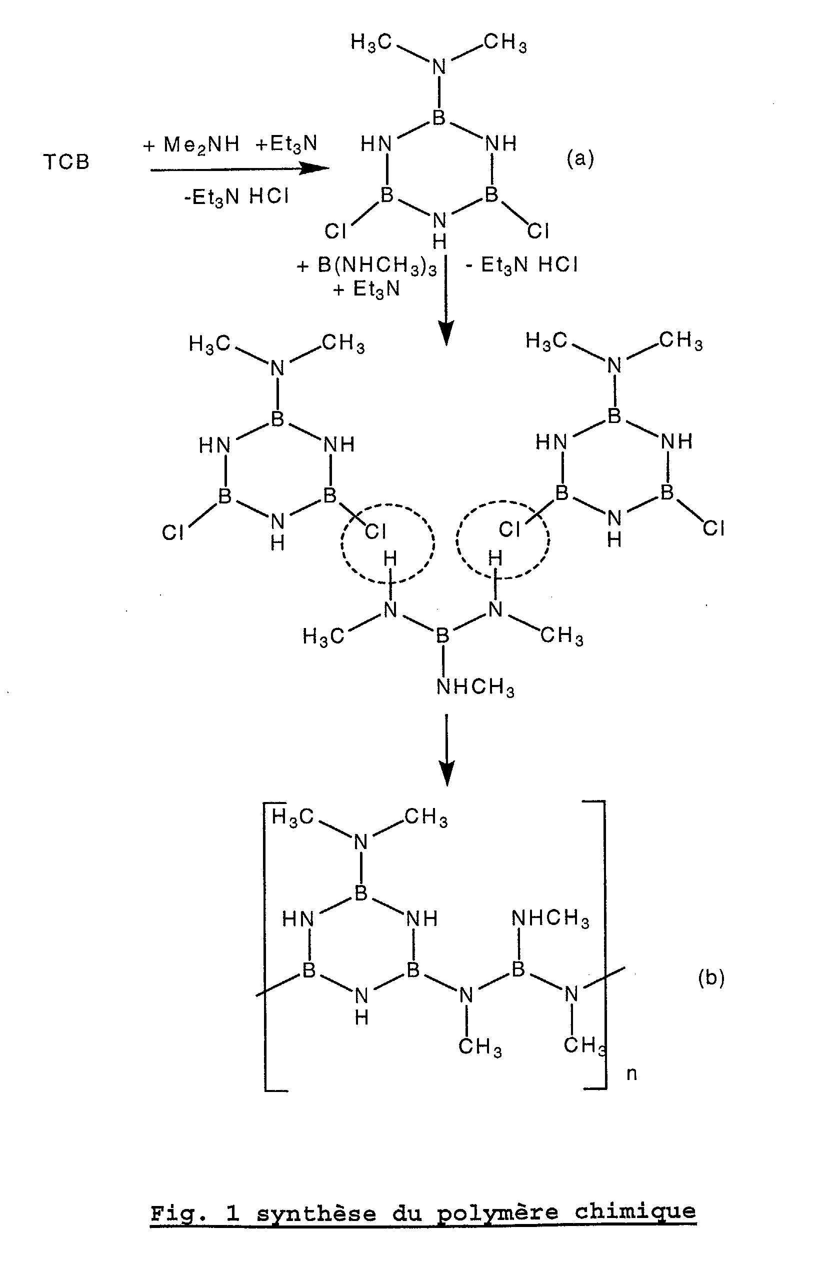

### EXEMPLE 2 : FILAGE DU POLYMERE CHIMIQUE : OBTENTION DE FIBRES DE NITRURE DE BORE (BN)

Dans l'exemple suivant, les fibres obtenues ont été caractérisées en spectrométrie Raman et en analyse chimique par spectroscopie électronique (ESCA) comme étant bien des fibres de nitrure de bore hexagonal exemptes de carbone. On a déterminé ensuite leur diamètre, leurs propriétés mécaniques et leur structures.

Les diamètres ont été évalués par la méthode d'interférométrie laser en utilisant l'approximation de Fraunhofer. Ce sont les monofilaments qui jouent le rôle de fente de diffraction. La technique consiste à mesurer la distance entre deux franges d'interférence consécutives en connaissant la longueur d'onde du laser et la distance du monofilament à l'écran de mesure.

Les propriétés mécaniques ont été déterminées à l'aide d'une machine de microtraction. Les cadres sur carton sont disposés dans les mors de telle sorte que l'essai corresponde à la traction du monofilament. Une force de traction est appliquée sur le monofilament. Les essais sont réalisés sur une cinquantaine de monofilaments en longueur d'éprouvette de 1 cm. Les tests de rupture sur ces filaments sont réalisés par le modèle de Weibull où les contraintes à rupture sont déterminées pour une probabilité de rupture égale à 0,63. On définit une valeur moyenne de la distribution des allongements à la rupture (ε_{R}) et à partir de cette valeur, on calcule la valeur médiane de la distribution des contraintes à rupture (σ_{R}) à une probabilité de survie de 0,37. On peut alors en déduire le module d'Young ou d'élasticité E.

L'état structural des filaments a été déterminé par diffraction des rayons X et diffusion Raman. La largeur à mi-hauteur de la raie de diffraction X (002) qui se situe à une valeur 2 θ de 26,765° pour le nitrure de bore hexagonal, apporte une information sur la cristallinité du filament suivant l'axe c.

Le polymère a été filé sur FILAMAT2 (marque de commerce), de la société PRODEMAT, avec une filière de 200µm, avec le polymère fabriqué comme indiqué dans l'exemple 1 ci-dessus,à une température de 151°C, en l'extrudant à une vitesse de 0,4 à 0,6 mm/min sous une force variant de 20 à 40 daN et en l'enroulant autour d'une bobine de graphite de 50 et 100mm de diamètre à une vitesse d'étirage de 40 à 200 cm/s.

Le polymère s'est très bien extrudé vers 90°C, le filage a été confortable. La température de filage est plus faible d'environ 100°C que celle qui doit être utilisée pour les polymères de l'art antérieur.

Un traitement de pré-céramisation sous ammoniac jusqu'à 600°C a ensuite été réalisé en vue d'éliminer les groupements méthyle du polymère de départ, puis sous azote jusqu'à 1800°C.

Les traitements thermiques de précéramisation et de céramisation effectués sont les suivants :

### Traitement thermique:

a) Précéramisation : chauffage jusqu'à 600°C, à une vitesse de 25°C/h, sous NH₃.
b) Céramisation :
   - Chauffage de 600 à 1100°C, à une vitesse de 100°C/h, sous N₂.
   - Maintien à 1100°C, sous N₂, pendant 90 minutes.
   - Refroidissement à la température ambiante.
   - Chauffage jusqu'à 1400°C, à une vitesse de 600°C/h, sous N₂.
   - Maintien à 1400°C, sous N₂, pendant 1 heure.
   - Chauffage de 1400 à 1600°C, à une vitesse de 600°C/h, sous N₂.
   - Maintien à 1600°C, sous N₂ pendant 1 heure.
   - Chauffage de 1600 à 1800°C, à une vitesse de 600°C/h, sous N₂.
   - Maintien à 1800°C, sous N₂, pendant 1 heure.

Le traitement s'effectue sous tension mécanique par retrait du polymère sur la bobine réfractaire lors de la montée en température. L'intérêt de poursuivre le traitement jusqu'à 1800°C est de cristalliser le nitrure de bore et d'orienter les cristaux de BN parallèlement à l'axe de la fibre.

On refroidit alors les fibres jusqu'à la température ambiante et on les caractérise mécaniquement et structurallement. Elles ont un aspect blanc et sont légèrement détendues autour de la bobine mais non cassés.

Les résultats des tests de traction obtenus sur les différents échantillons réalisés sont récapitulés dans le tableau I ci-dessous.

Dans ce tableau, E1 et E2 représentent des échantillons différents réalisés suivant le procédé de cet exemple, V représente : vitesse de bobinage, Φ : diamètre des fibres, σ_{R} : la contrainte à la rupture, et E : le module d'élasticité.

Des spectres RX et Raman ont été enregistrés sur ces fibres, ils sont caractéristiques de nitrure de bore hexagonal cristallisé.

C'est la première fois, grâce au procédé de la présente invention, qu'un polymère élaboré chimiquement peut être filé confortablement.

Ce résultat est d'autant plus remarquable que les caractéristiques mécaniques sont bonnes, on atteint en un seul essai 1000 MPa de contrainte à rupture quasiment autant qu'avec les poly(amino)borazines thermiques de l'art antérieur.

**TABLEAU I**

| | **E1** | **E2** |
|---|---|---|
| **Bobine** (mm) | 100 | 100 |
| **V**_{**bobinage**} (cm/sec) | 120 | 142 |
| **V**_{**piston**} (mm/min) | 0.4 | 0.4-0.6 |
| **φ**_{**th**} **crues (µm)** | 22,5 | 20,8 - 25,5 |
| **φ céramisées (µm)** | 10,0 | 9,3 |
| **σ**_{**R**} **(MPa)** | 855 | 1021 |
| **E (GPa)** | 151 | 187 |

La présente invention permet d'obtenir des fibres de nitrure de bore aux propriétés élevées à partir d'un nouveau type de polymère élaboré à température ambiante.

### EXEMPLE 3 : COMPARATIF

Un polymère chimique a été obtenu par réaction d'un trichloroborazine (TCB) sur n B(NHⁱPr)₃, avec 1<n<3 et ⁱPr : isopropyle. Dans ce cas, l'aminoborane utilisé était le tris(isopropylamino)borane.

Un essai de filage a été effectué. Seuls quelques filaments de BN ont été obtenus après traitement thermique mais ils ont été céramisés non tendus.

Ces filaments présentaient des propriétés mécaniques très faibles et le polymère était réticulé dans toutes les directions.

Les inconvénients que comporte cette méthode de l'art antérieur sont : la non-stoechiométrie, l'absence de pseudo-linéarité du polymère qui entraîne une mise en forme difficile, et un rendement céramique très faible.

Ces problèmes n'apparaissent pas dans la mise en oeuvre selon la présente invention, notamment dans celle présentée dans les exemples ci-dessus.

### LISTE DE REFERENCES

**[1] :** R.T. PAINE et al, Chem. Rev., 90, 1990, pp. 73-91.
**[2] :** C. K. Narula et al dans Chem. Mater, 2, 1990, pp. 384-389.
**[3] :** EP-A-0 342 673.
**[4] :** FR-A-2 695 645.
**[5] :** T. Wideman et al, Chem. Mater., 10, 1998, pp. 412-421.

## Revendications

1. Polymère de formule (I) suivante : 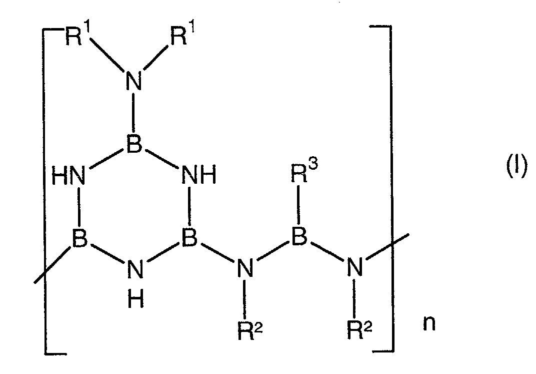 dans laquelle n est un nombre entier, R¹ et R², identiques ou différents, représentent indépendamment un groupe alkyle, et R³ représente un groupe amino, un atome d'hydrogène, un alkyle, un cycloalkyle ou un boryle.

2. Polymère selon la revendication 1, dans lequel R¹ et R² représentent indépendamment un alkyle ayant de 1 à 3 atomes de carbone, et R³ représente indépendamment une alkylamine.

3. Polymère selon la revendication 1, dans lequel R¹ représente le groupe méthyle.

4. Polymère selon la revendication 1, dans lequel R¹ et R² représentent le groupe méthyle.

5. Polymère selon la revendication 1, dans lequel R¹ et R² représentent le groupe méthyle et R³ représente NHCH₃.

6. Procédé de fabrication de fibres de nitrure de bore par filage d'un polymère précurseur et céramisation des fibres de polymère obtenues par filage, dans lequel le polymère précurseur est de formule (I) suivante : 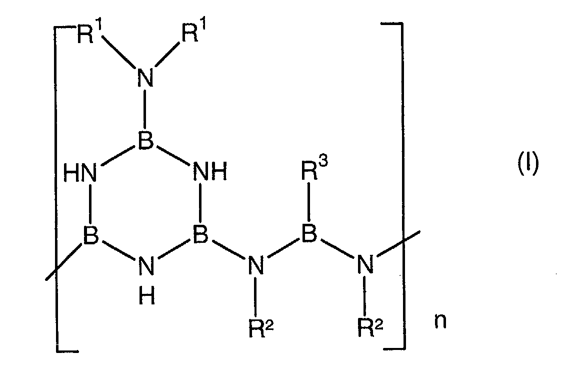 dans laquelle n est un nombre entier, R¹ et R², identiques ou différents, représentent indépendamment un groupe alkyle, et R³ représente un groupe amino, un atome d'hydrogène, un alkyle, un cycloalkyle ou un boryle.

7. Procédé selon la revendication 6, dans lequel R¹ et R² représentent indépendamment un alkyle ayant de 1 à 3 atomes de carbone, et R³ représente indépendamment une alkylamine.

8. Procédé selon la revendication 6, dans lequel R¹ représente le groupe méthyle.

9. Procédé selon la revendication 6, dans lequel R¹ et R² représentent le groupe méthyle.

10. Procédé selon la revendication 6, dans lequel R¹ et R² représentent le groupe méthyle et R³ représente NHCH₃.

11. Procédé selon la revendication 6, dans lequel la polymérisation est effectuée à une température de 10 à 35°C sous atmosphère inerte.

12. Procédé selon la revendication 6, dans lequel on effectue le filage à une température de filage Tf telle que 30°C ≤ Tf - Tg ≤ 100°C, avec Tf la température de filage et Tg la température de transition vitreuse du polymère.

13. Procédé selon l'une quelconque des revendications 6 à 12, dans lequel on effectue le filage dans une atmosphère ayant un taux d'humidité inférieur à 10 %.

14. Procédé selon la revendication 6, dans lequel l'étape de céramisation est réalisée en deux étapes, en réalisant une première étape de précéramisation avec de l'ammoniac jusqu'à une température inférieure ou égale à 1000°C, puis en réalisant une deuxième étape de céramisation en atmosphère d'azote et/ou de gaz rare à des températures supérieures, notamment de 1400 à 2200°C, en une ou plusieurs opérations successives.

15. Procédé selon l'une quelconque des revendications 6 à 14 précédentes, dans lequel le polymère précurseur de formule (I) est obtenu par la mise en oeuvre des étapes suivantes :
- Réaction de HN(R¹)₂ sur la trichloroborazine en proportion stoechiométrique 1/1 en moles pour donner le borazine de formule (II) suivante : 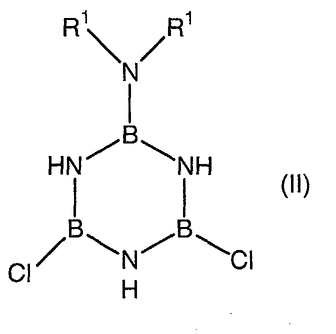
- réaction sans chauffage du borazine de formule (II) avec un alkylaminoborane de formule R³B(NHR²)₃ en proportions stoechiométriques 1/1 en moles, en présence d'une amine tertiaire -N(R⁴)₃, de manière à obtenir ledit polymère précurseur de formule (I),
dans lequel R¹, R² et R³ étant tels que définis dans la revendication 6, et R⁴ est un groupe alkyle.

16. Procédé selon la revendication 15, dans lequel R⁴ est un groupe alkyle comprenant de 1 à 3 atomes de carbone.

17. Procédé selon la revendication 15, dans lequel R⁴ est le groupe éthyle.

18. Fibre de nitrure de bore obtenue par un procédé selon l'une quelconque des revendications 6 à 17 précédentes.

19. Utilisation d'un polymère selon l'une quelconque des revendications 1 à 5 en tant que précurseur pour la fabrication de fibres de nitrure de bore.

20. Utilisation de fibres de nitrure de bore selon la revendication 19, pour la fabrication de matériaux composites.

21. Utilisation de fibres de nitrure de bore selon la revendication 19, pour la fabrication de composites BN/BN, de pièces structurales ou de radômes d'antennes hautes températures structuraux.

22. Utilisation d'un polymère selon l'une quelconque des revendications 1 à 5 pour la fabrication de revêtement protecteurs contre l'oxydation, de mousses de nitrure de bore, de matériaux composites BN/C ou BN/BN ou de puits de chaleur pour la microélectronique.
